# EUROPEAN PATENT SPECIFICATION

(11) **EP 4 537 120 B1**
(45) Date of publication and mention of the grant of the patent: **29.04.2026**
(21) Application number: 22732577.6
(22) Date of filing: 13.06.2022
(51) Int. Cl.: H01M 8/0432, H01M 8/04992, H01M 8/249

(54) **A COMPUTER-IMPLEMENTED METHOD FOR CONTROLLING OPERATION OF AT LEAST TWO FUEL CELL SYSTEMS**
EIN COMPUTER-IMPLEMENTIERTES VERFAHREN ZUR STEUERUNG DES BETRIEBES VON MINDESTENS ZWEI BRENNSTOFFZELLENSYSTEMEN
PROCEDE MIS EN OEUVRE PAR ORDINATEUR POUR COMMANDER LE FONCTIONNEMENT D'AU MOINS DEUX SYSTEMES DE PILE A COMBUSTIBLE

(43) Date of publication of application: 16.04.2025
(73) Proprietor: Volvo Truck Corporation, 405 08 Göteborg (SE)
(72) Inventor: ARYA, Pranav, 437 42 Lindome (SE)
(74) Representative: Kransell & Wennborg KB
(86) International application number: PCT/EP2022/066027
(87) International publication number: WO 2023/241780

(56) References cited:
- EP-A1- 1 923 945
- EP-A1- 4 006 563
- WO-A1-2016/146971
- WO-A1-2021/004599
- WO-A1-2021/213654
- JP-A- 2008 130 424
- US-A1- 2013 065 090

## Description

### TECHNICAL FIELD

The invention relates to a computer-implemented method for controlling operation of at least two fuel cell systems. The invention also relates to a control unit, a propulsion system, a vehicle, a computer program and a computer readable medium.

The invention can be applied in heavy-duty vehicles, such as trucks, buses and construction equipment. Although the invention will be described with respect to a truck, the invention is not restricted to this particular vehicle, but may also be used in other vehicles such as wheel loaders, excavators, dump trucks, passenger cars etc. The invention may also be applicable for non-vehicle applications.

### BACKGROUND

There are many different techniques for generating propulsive force for a vehicle. One such technique is to use electric power for driving one or more electric machines of the vehicle. The electric machines can be powered by use of a plurality of fuel cell systems. A fuel cell is an electrochemical cell which converts chemical energy into electricity. The fuel cell converts the chemical energy of a fuel, typically hydrogen, and an oxidizing agent, typically oxygen, into electricity. Accordingly, a fuel cell can be used as an alternative or as a complement to electric batteries. In recent years fuel cells have been considered for powering electric vehicles, such as pure electric vehicles and hybrid electric vehicles.

Fuel cell systems which are used in combination for e.g. powering a vehicle are prone to degradation during use. The degradation negatively affects the service life of the systems. As such, it is of high importance to try to reduce the amount of degradation for the systems, thereby increasing the service life. WO 2021/213654 A1 concerns a method of monitoring battery ageing of a battery unit in an energy storage system of a vehicle.

EP 4 006 563 A1 relates to a method for predicting service life of a battery unit.

In view of the above, there is a strive to increase the service life of such systems and the present invention is directed towards the situation when at least two fuel cell systems are used for providing power.

### SUMMARY

Thus, an object of the invention is to provide an improved method for controlling operation of at least two fuel cell systems, or at least to provide a suitable alternative. In particular, an object of the invention is to increase the service life of the combined system. Other objects of the invention are to provide an improved control unit, an improved propulsion system, an improved vehicle, a computer program and/or a computer readable medium, or at least to provide suitable alternatives.

According to a first aspect of the invention, the object is at least partly achieved by a method according to claim 1.

Thus, a computer-implemented method for controlling operation of at least two fuel cell systems is provided.

Each fuel cell system is adapted to be operated with adjustable operating dynamics and/or in an adjustable operating window defining operating constraints for the fuel cell system, wherein increasing the operating dynamics and/or the operating window is associated with an increased expected degradation of the fuel cell system and wherein reducing the operating dynamics and/or the operating window is associated with a reduced expected degradation of the fuel cell system.

The method comprises:
- obtaining an estimated actual state of health of each fuel cell system,
- comparing the actual states of health of the fuel cell systems, and when the comparison is indicative of a predefined difference between the actual states of health of the fuel cell systems:
- identifying a first fuel cell system of the at least two fuel cell systems having a lowest actual state of health of the at least two fuel cell systems,
- comparing the actual state of health of the first fuel cell system with a determined expected state of health of the first fuel cell system, wherein the expected state of health is based on historical use conditions of the first fuel cell system, and
- when the actual state of health of the first fuel cell system is worse than its expected state of health, reducing the operating dynamics and/or the operating window of the first fuel cell system and increasing the operating dynamics and/or the operating window of the other fuel cell system.

The fuel cell systems are adapted to be controlled individually, i.e. the operating dynamics and/or the operating window for one of the systems can be increased while at the same time the operating dynamics and/or the operating window of the other fuel cell system can be decreased.

By operating dynamics of a system is herein meant how the operation of the system is varied over time. For example, large and/or rapid variations of an operating parameter during use represent higher operating dynamics of the system compared to a situation with smaller and/or slower variations of the operating parameter. This may also be referred to as a slew rate of the system. By an operating window is herein meant a window, or range, within which an operating parameter is during use. By way of example, an operating parameter may refer to a power output from the system. As such, operating dynamics may be defined as power dynamics of the fuel cell system, e.g. how fast the fuel cell system can go from low power to high or full power. Other non-limiting examples of operating parameters are voltage level, ampere level and power throughput. As yet another non-limiting example, an operating parameter may relate to if a shutdown of the system is allowed or not. For example, too many shutdowns of the fuel cell system may result in higher degradation.

By the provision of a method as disclosed herein, i.e. by controlling the operation of the fuel cell systems as disclosed herein, a more similar, or balanced, level of degradation of the fuel cell systems can be achieved. In other words, the service life of the fuel cell systems can be balanced out so that the service life of the combined system is increased. In addition, by the present invention, a requested power need for e.g. a vehicle can be fulfilled while at the same time assuring that the service life of the combined system is not negatively affected.

The present invention is based on a realization that an expected state of health based on historical use conditions of a fuel cell system is not always the same as the actual state of health. A reason for this is that it may be difficult to assess the real operating conditions of the fuel cell system. Therefore, depending on the actual operating conditions during use, i.e. during operation, the fuel cell system may degrade less or more than expected. As such, by controlling operation based on the above-mentioned deviation, an unexpected degradation of the fuel cell system which is higher than an expected degradation based on the historical use conditions can be managed by allowing the other fuel cell system to be used more. As a result, the service life of the combined system may be extended since the service life of the combined system is based on the service life of the weakest fuel cell system. In addition, as another example, it has been realized that the actual state of health can be different from the expected state of health due to piece to piece variations of the fuel cell systems. Still further, there may be noise factors in actual operation that may not be accounted for when determining the expected state of health. By the comparison of the actual state of health and the expected state of health as disclosed herein, the impact of these noise factors may be accounted for.

By state of health is herein meant a level of degradation of the fuel cell system which affects the remaining lifetime of the fuel cell system. For example, 100 % state of health implies that the system is new and not used, whereas 50 % state of health implies that the remaining lifetime is 50 % of the total lifetime of the system.

Optionally, when the comparison of the actual states of health of the fuel cell systems is indicative of no difference between the actual states of health of the fuel cell systems, the method comprises operating the fuel cell systems with the same operating dynamics and/or in the same operating window.

Optionally, the result of the comparison between the actual states of health of the fuel cell systems is indicative of the predefined difference when a difference therebetween exceeds a predefined difference threshold. Thereby, unnecessary adjustments which only would have a slight effect on the combined service life, or even no effect at all, can be avoided. The predefined difference threshold may for example correspond to a difference of 1-5 % in actual state of health.

Optionally, the method further comprises:
- when the actual state of health of the first fuel cell system is better than its expected state of health, operating the fuel cell systems with the same operating dynamics and/or in the same operating window. This also implies increased service life of the combined system, i.e. this situation may be indicative of a satisfying power distribution between the fuel cell systems.

Optionally, the reducing of the operating dynamics and/or the operating window of the first fuel cell system and the increasing of the operating dynamics and/or the operating window of the other fuel cell system are done so that combined operating dynamics and/or a combined operating window of the at least two fuel cell systems is/are kept unchanged. Thereby it can be assured that a required power output from the at least two fuel cell systems is fulfilled.

Optionally, the method is initiated in response to obtaining a request to activate all of the at least two fuel cell systems. Thereby, the method can be initiated only when needed, implying increased efficiency, reduced need of processing power, etc.

Optionally, the historical use conditions of the first fuel cell system comprise at least one of the following:
- power output of the fuel cell system during operation,
- operating dynamics of the fuel cell system during operation,
- power cycling frequency of the fuel cell system during operation,
- ambient temperature conditions during operation,
- ambient air conditions during operation, such as level of pollution,
- ambient weather conditions during operation,
- start/stop history,
- history of coolant temperature in the fuel cell system,
- operating time.

Optionally, during operation of the fuel cell systems, the method is updated with a predetermined update frequency, such as an update frequency corresponding to a predetermined number of operating hours of at least one of the fuel cell systems. Updating with a predetermined update frequency implies a more reliable method. For example, the predetermined update frequency may be set so that the deviation of the actual and expected states of health does not exceed a threshold. As yet another example, the predetermined update frequency may additionally or alternatively be set so that the deviation of the actual states of health of the fuel cell systems does not exceed a threshold. The aforementioned thresholds could for example be in the range of 1-5 %. For example, the predetermined update frequency may be set as a function of the deviation(s), e.g. the higher the deviation(s), the higher is the update frequency.

Optionally, the predetermined update frequency is variable, such as variable with respect to at least one of ambient temperature conditions and ambient weather conditions. A variable update frequency implies a more flexible method, e.g. allowing the update frequency to vary with ambient conditions. For example, more harsh ambient conditions may imply the need for a higher update frequency, and vice versa.

Optionally, the predetermined update frequency is modified during operation based on a magnitude of the difference in the actual state of health between the fuel cell systems. For example, a larger difference in the actual state of health between the fuel cell systems may imply a higher update frequency, and vice versa.

According to a second aspect of the invention, the object is at least partly achieved by a control unit according to claim 11.

Thus, a control unit for controlling operation of at least two fuel cell systems is provided. The control unit is configured to perform the steps of the method according to any one of the embodiments of the first aspect of the invention.

Advantages and effects of the second aspect are analogous to the advantages and effects of the first aspect of the invention.

According to a third aspect of the invention, the object is at least partly achieved by a propulsion system according to claim 12.

Thus, a propulsion system for a vehicle is provided. The propulsion system comprises at least two fuel cell systems, and further comprises a control unit according to the second aspect of the invention.

Advantages and effects of the third aspect are analogous to the advantages and effects of the first and second aspects of the invention.

According to a fourth aspect of the invention, the object is at least partly achieved by a vehicle according to claim 13. Thus, a vehicle comprising a propulsion system according to the third aspect of the invention is provided.

According to a fifth aspect of the invention, the object is at least partly achieved by a computer program according to claim 14. Thus, a computer program comprising program code means for performing the steps of the method according to any embodiment of the first aspect of the invention when said program is run on a computer, such as on the control unit according to the second aspect of the invention.

According to a sixth aspect of the invention, the object is at least partly achieved by a computer readable medium according to claim 15. Thus, a computer readable medium carrying a computer program comprising program code means for performing the steps of the method according to any embodiment of the first aspect of the invention when said program is run on a computer, such as on the control unit according to the second aspect of the invention.

Further advantages and advantageous features of the invention are disclosed in the following description and in the dependent claims.

### BRIEF DESCRIPTION OF THE DRAWINGS

With reference to the appended drawings, below follows a more detailed description of embodiments of the invention cited as examples.

In the drawings:
Fig. 1 is a side view of a vehicle according to an example embodiment of the present invention,
Fig. 2 is a flowchart of a method according to an example embodiment of the present invention,
Fig. 3 is a flowchart of a method according to another example embodiment of the present invention,
Fig. 4 is a schematic illustration of a propulsion system according to an example embodiment of the present invention, and
Fig. 5 is a graph showing an expected and actual state of health over time.

### DETAILED DESCRIPTION OF EXAMPLE EMBODIMENTS OF THE INVENTION

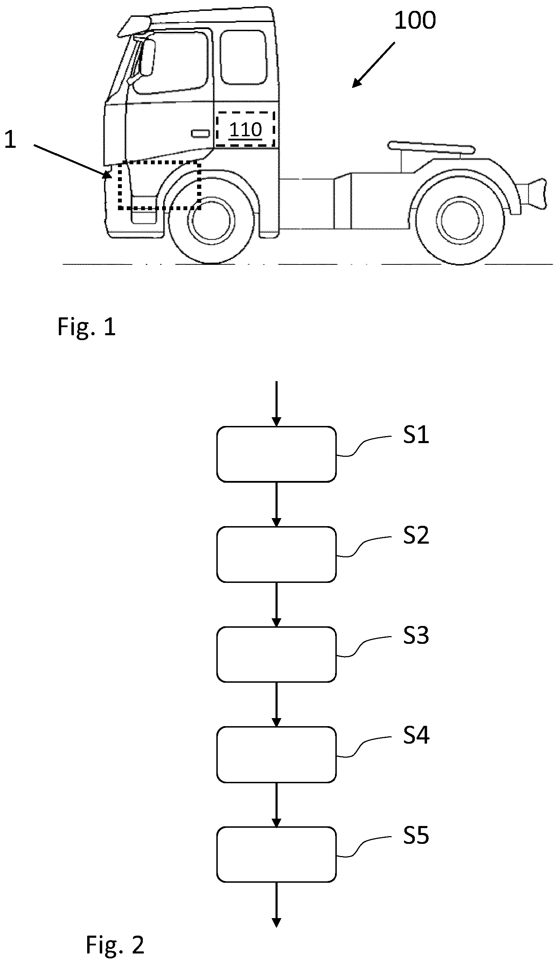

Fig. 1 depicts a vehicle 100 in the form of a heavy-duty truck. In this case, the heavy-duty truck 100 is a so-called towing vehicle which is configured to tow one or more trailers (not shown). The present invention is however not only applicable to this type of vehicle but may also be used in many other types of vehicles and vessels, such as other trucks, buses, passenger cars, construction equipment, including but not limited to wheel loaders, dump trucks, excavators etc.

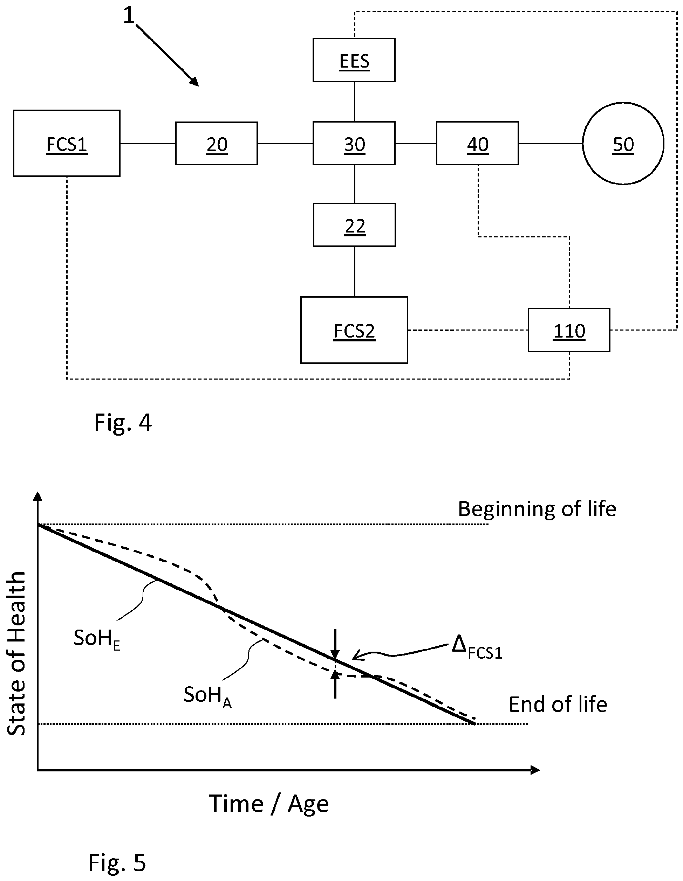

In the shown embodiment, the vehicle 100 comprises a propulsion system 1. The propulsion system 1 may for example be a propulsion system 1 as shown in fig. 4 which will be described further in the below. The vehicle 100 further comprises a control unit 110 according to an example embodiment of the second aspect of the invention.

In particular, the propulsion system 1 comprises a fuel cell system, FCS1, and another fuel cell system, FCS2. The propulsion system 1 may, as further shown in fig. 4, comprise an electrical energy storage system EES. For example, the electrical energy storage system EES may be an electric battery, such as a lithium-ion battery, and/or a capacitor.

Typically, such a propulsion system 1 for the vehicle 1 is adapted so that, during operation, the fuel cell systems FCS1, FCS2 contribute the most to the propulsion of the vehicle 1, whereas the EES is used to compensate for situations when the fuel cell systems FCS1, FCS2 can't provide, or are not suitable for providing, all of the required propulsion force.

Fig. 2 depicts a flowchart of a computer-implemented method according to an example embodiment of the present invention. The method controls operation of at least two fuel cell systems FCS1, FCS2.

Each fuel cell system FCS1, FCS2 is adapted to be operated with adjustable operating dynamics and/or in an adjustable operating window defining operating constraints for the fuel cell system FCS1, FCS2. Increasing the operating dynamics and/or the operating window is associated with an increased expected degradation of the fuel cell system FCS1, FCS2 and reducing the operating dynamics and/or the operating window is associated with a reduced expected degradation of the fuel cell system FCS1, FCS2.

The method comprises:
S1: obtaining an estimated actual state of health of each fuel cell system FCS1, FCS2,
S2: comparing the actual states of health of the fuel cell systems FCS1, FCS2, and when the comparison is indicative of a predefined difference between the actual states of health of the fuel cell systems FCS1, FCS2:
S3: identifying a first fuel cell system of the at least two fuel cell systems FCS1, FCS2 having a lowest actual state of health of the at least two fuel cell systems FCS1, FCS2,
S4: comparing the actual state of health of the first fuel cell system with a determined expected state of health of the first fuel cell system, wherein the expected state of health is based on historical use conditions of the first fuel cell system, and
S5: when the actual state of health of the first fuel cell system is worse than its expected state of health, reducing the operating dynamics and/or the operating window of the first fuel cell system and increasing the operating dynamics and/or the operating window of the other fuel cell system.

The first fuel cell system may be any one of the fuel cell systems FCS1, FCS2.

For example, an actual state of health for the fuel cell systems FCS1, FCS2 may be estimated by the so-called electrochemical impedance spectroscopy method which is well-known. There are also other methods for estimating an actual state of health, such as polarization curve comparison between a used fuel cell system and a new, or fresh, fuel cell system. Still further, by way of example, an actual state of health may be estimated as disclosed in any one of US8907675B2 and US10345389B2.

An expected state of health based on historical use conditions may for example be determined by comparing a current usage with a maximum usage. For example, the first fuel cell system may in a certain application be supposed to last for a specific amount of operating hours, such as 1000 hours. During this time it may be assumed that the degradation characteristics is known, such as linear. As such, if for example the first fuel cell system has been operated for 500 hours, then, with a linear logic, the expected state of health should be 50 %. This is a rather simple and thereby efficient approach of estimating the expected state of health. However, more advanced approaches are also feasible. For example, by taking at least one of the other below mentioned historical use conditions into account, any event that is related to degradation of the first fuel cell system, such as ambient temperature, start/stop history etc, can be considered to thereby obtain a value of the expected state of health which may be closer to the actual state of health. For example, an expected state of health based on historical use conditions may be determined by use of tests. By way of example, an empirical model may be created which is based on tests performed under different use conditions, e.g. based on one or more use conditions which correspond to the herein mentioned historical use conditions. Thereby, an improved value of the expected state of health may be obtained.

An example of an actual SoH_{A} and an expected SoH_{E} state of health over time of one of the fuel cell systems, in this case the fuel cell system FCS1, is shown in fig. 5. Fig. 5 represents a graph where state of health is represented on the y-axis and where time, or age, is represented on the x-axis. The dotted curve represents the actual state of health SoH_{A} and the solid curve represents the expected state of health SoH_{E}. In the example shown, the expected state of health SoH_{E} forms an almost straight line which is based on historical use conditions of the fuel cell system FCS1. A straight line may for example imply that the use conditions are substantially static during operation. For example, a power cycling frequency, ambient temperature conditions during operation etc., may not substantially vary over time. Of course, the historical use conditions may additionally, or alternatively, vary over time, resulting in a varying degradation rate over time. Thereby, the expected state of health may evidently not only be represented by a straight line. Historical use conditions as used herein may refer to any previous use conditions of the fuel cell system FCS1, FCS2.

An example when the actual state of health SoH_{A} of the first fuel cell system FCS1 is worse than its expected state of health SoH_{E} is indicated by ΔFCS1 in fig. 5. As such, when this situation is identified by the comparison performed in S5, the operating dynamics and/or the operating window of the first fuel cell system FCS1 is reduced and the operating dynamics and/or the operating window of the other fuel cell system FCS2 is increased.

For example, the result of the comparison between the actual states of health of the fuel cell systems FCS1, FCS2 may be indicative of the predefined difference when a difference therebetween exceeds a predefined difference threshold. Thereby, unnecessary adjustments which only would have a slight effect on the combined service life, or even no effect at all, can be avoided. The predefined difference threshold may for example correspond to a difference of 1-5 % in actual state of health.

Additionally, or alternatively, the reducing of the operating dynamics and/or the operating window of the first fuel cell system FCS1 and the increasing of the operating dynamics and/or the operating window of the other fuel cell system FCS2 may be done so that combined operating dynamics and/or a combined operating window of the at least two fuel cell systems FCS1, FCS2 is/are kept unchanged.

The historical use conditions of the first fuel cell system FCS1 may comprise at least one of the following:
- power output of the fuel cell system during operation,
- operating dynamics of the fuel cell system during operation,
- power cycling frequency of the fuel cell system during operation,
- ambient temperature conditions during operation,
- ambient air conditions during operation, such as level of pollution,
- ambient weather conditions during operation,
- start/stop history,
- history of coolant temperature in the fuel cell system,
- operating time.

During operation of the fuel cell systems FCS1, FCS2, the method may be updated with a predetermined update frequency, such as an update frequency corresponding to a predetermined number of operating hours of at least one of the fuel cell systems FCS1, FCS2.

The predetermined update frequency may further be variable, such as variable with respect to at least one of ambient temperature conditions and ambient weather conditions.

The predetermined update frequency may additionally or alternatively be modified during operation based on a magnitude of the difference in the actual state of health between the fuel cell systems FCS1, FCS2.

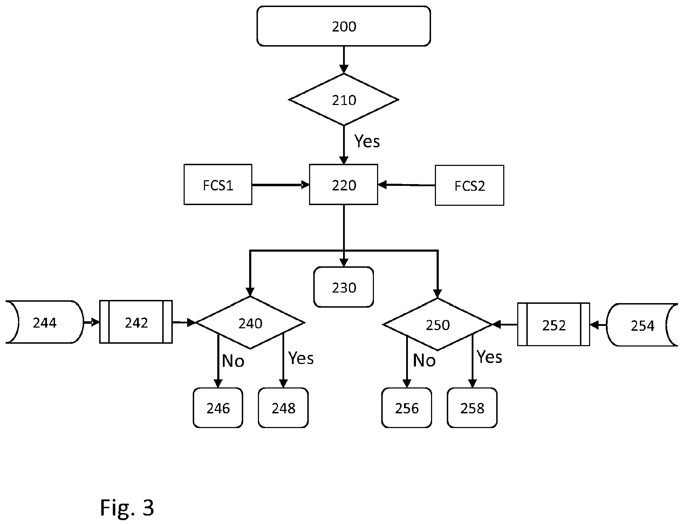

Fig. 3 depicts another embodiment of a method according to the invention.

The box 200 represents when the vehicle 100 is started, i.e. turned on or activated.

The method may be initiated in response to obtaining a request to activate all of the at least two fuel cell systems FCS1, FCS2. This is herein represented by activating both fuel cell systems FCS1, FCS2.

The method may accordingly comprise an initial step 210 of determining a need to activate all of the at least two fuel cell systems FCS1, FCS2. If the answer is yes, the method may be continued to 220 as shown in fig. 3.

In 220, information about an estimated actual state of health of each fuel cell system FCS1, FCS2 is obtained. This is represented by the arrows from each fuel cell system FCS1, FCS2 to the box 220.

In 220, the actual states of health of the fuel cell systems FCS1, FCS2 are compared, and when the comparison is indicative of a predefined difference between the actual states of health of the fuel cell systems FCS1, FCS2, the method is either continued to 240 or 250.

However, when the comparison of the actual states of health of the fuel cell systems FCS1, FCS2 is indicative of no difference between the actual states of health of the fuel cell systems FCS1, FCS2, the method is instead continued to 230. In 230, the fuel cell systems FCS, FCS2 are operated with the same operating dynamics and/or in the same operating window.

The method is continued from 220 to 240 when the actual state of health of the fuel cell system FCS1 is worse than the actual state of health of the fuel cell system FCS2, and from 220 to 250 when the actual state of health of the fuel cell system FCS2 is worse than the actual state of health of the fuel cell system FCS1.

In 240, the actual state of health of the fuel cell system FCS1 is compared with a determined expected state of health of the fuel cell system FCS1, wherein the expected state of health is based on historical use conditions of the fuel cell system FCS1.

The expected state of health of the fuel cell system FCS1 is determined in box 242. The historical use conditions may for example be obtained from a database or memory, represented by box 244.

When the actual state of health of the fuel cell system FCS1 is worse than its expected state of health, the operating dynamics and/or the operating window of the fuel cell system FCS1 is/are reduced and the operating dynamics and/or the operating window of the other fuel cell system FCS2 is/are increased. This is represented by box 248 in fig. 3.

On the other hand, when the actual state of health of the fuel cell system FCS1 is better than its expected state of health, the fuel cell systems FCS1, FCS2 are operated with the same operating dynamics and/or in the same operating window. This is represented by box 246 in fig. 3.

In 250, the actual state of health of the fuel cell system FCS2 is compared with a determined expected state of health of the fuel cell system FCS2, wherein the expected state of health is based on historical use conditions of the fuel cell system FCS2.

The expected state of health of the fuel cell system FCS2 is determined in box 252. The historical use conditions may for example be obtained from a database or memory, represented by box 254.

When the actual state of health of the fuel cell system FCS2 is worse than its expected state of health, the operating dynamics and/or the operating window of the fuel cell system FCS2 is/are reduced and the operating dynamics and/or the operating window of the other fuel cell system FCS1 is/are increased. This is represented by box 258 in fig. 3.

On the other hand, when the actual state of health of the fuel cell system FCS2 is better than its expected state of health, the fuel cell systems FCS1, FCS2 are operated with the same operating dynamics and/or in the same operating window. This is represented by box 256 in fig. 3.

Fig. 4 depicts schematically a propulsion system 1 for a vehicle according to an example embodiment of the invention. The propulsion system 1 comprises a fuel cell system FCS1 and another fuel cell system FCS2. As shown, the propulsion system 1 may further comprise an electrical energy storage system EES. The propulsion system 1 may for example be part of the vehicle 100 as shown in fig. 1. In the shown embodiment, the propulsion system 1 further comprises a respective DC/DC converter 20, 22 for the respective fuel cell systems FCS1, FCS2. It further comprises a junction box 30 and an electrical machine 40 which is drivingly connected to at least one traction wheel 50 of the vehicle 100. As such, the solid lines between the parts in the figure represent electrical connections, except for the line between the electrical machine 40 and the at least one traction wheel 50 which instead represents a mechanical driving connection. The operation of the fuel cell systems FCS1, FCS2, and of the electrical energy storage system EES is controlled by a control unit 110. The control unit 110 may further be used for controlling operation of the propulsion system 1, i.e. also for controlling e.g. the electrical machine 40. The fuel cell systems FCS1, FCS2 are preferably adapted to be the main contributors for providing propulsive power to the at least one traction wheel 50. Accordingly, the electrical energy storage system EES is preferably adapted to provide additional propulsive power in situations when the complete requested power cannot be provided by the fuel cell systems FCS1, FCS2, or when it is not suitable to provide the complete requested power by the fuel cell systems FCS1, FCS2.

The control unit 110 is herein an electronic control unit. It may comprise processing circuitry which is adapted to run a computer program as disclosed herein. The control unit 110 may comprise hardware and/or software for performing the method according to the invention. In an embodiment the control unit 110 may be denoted a computer. The control unit 110 may be constituted by one or more separate sub-control units. In addition, the control unit 110 may communicate with the propulsion system 1 by use of wired and/or wireless communication means. This is indicated by dashed lines in fig. 4. The control unit 110 may be part of the vehicle 100 as shown in fig. 1. Still further, even though the control unit 110 preferably is a vehicle on-board control unit, it shall be noted that the control unit 110 may additionally or alternatively be a vehicle off-board control unit, such as a control unit being part of a computer cloud system.

It is to be understood that the present invention is not limited to the embodiments described above and illustrated in the drawings; rather, the skilled person will recognize that many changes and modifications may be made within the scope of the appended claims.

## Claims

1. A computer-implemented method for controlling operation of at least two fuel cell systems (FCS1, FCS2), wherein each fuel cell system is adapted to be operated with adjustable operating dynamics and/or in an adjustable operating window defining operating constraints for the fuel cell system, wherein increasing the operating dynamics and/or the operating window is associated with an increased expected degradation of the fuel cell system and wherein reducing the operating dynamics and/or the operating window is associated with a reduced expected degradation of the fuel cell system, the method comprising:
- obtaining (S1) an estimated actual state of health of each fuel cell system (FCS1, FCS2),
- comparing (S2) the actual states of health of the fuel cell systems (FCS1, FCS2), and when the comparison is indicative of a predefined difference between the actual states of health of the fuel cell systems (FCS1, FCS2):
- identifying (S3) a first fuel cell system of the at least two fuel cell systems (FCS1, FCS2) having a lowest actual state of health of the at least two fuel cell systems (FCS1, FCS2),
- comparing (S4) the actual state of health of the first fuel cell system with a determined expected state of health of the first fuel cell system, wherein the expected state of health is based on historical use conditions of the first fuel cell system, and
- when the actual state of health of the first fuel cell system is worse than its expected state of health, reducing (S5) the operating dynamics and/or the operating window of the first fuel cell system and increasing (S5) the operating dynamics and/or the operating window of the other fuel cell system.

2. The method according to claim 1, wherein, when the comparison of the actual states of health of the fuel cell systems (FCS1, FCS2) is indicative of no difference between the actual states of health of the fuel cell systems (FCS1, FCS2), the method comprises operating the fuel cell systems with the same operating dynamics and/or in the same operating window.

3. The method according to any one of the preceding claims, wherein the result of the comparison between the actual states of health of the fuel cell systems (FCS1, FCS2) is indicative of the predefined difference when a difference therebetween exceeds a predefined difference threshold.

4. The method according to any one of the preceding claims, further comprising:
- when the actual state of health of the first fuel cell system is better than its expected state of health, operating the fuel cell systems (FCS1, FCS2) with the same operating dynamics and/or in the same operating window.

5. The method according to any one of the preceding claims, wherein the reducing of the operating dynamics and/or the operating window of the first fuel cell system and the increasing of the operating dynamics and/or the operating window of the other fuel cell system are done so that combined operating dynamics and/or a combined operating window of the at least two fuel cell systems (FCS1, FCS2) is/are kept unchanged.

6. The method according to any one of the preceding claims, wherein the method is initiated in response to obtaining a request to activate all of the at least two fuel cell systems (FCS1, FCS2).

7. The method according to any one of the preceding claims, wherein the historical use conditions of the first fuel cell system comprise at least one of the following:
- power output of the fuel cell system during operation,
- operating dynamics of the fuel cell system during operation,
- power cycling frequency of the fuel cell system during operation,
- ambient temperature conditions during operation,
- ambient air conditions during operation, such as level of pollution,
- ambient weather conditions during operation,
- start/stop history,
- history of coolant temperature in the fuel cell system,
- operating time.

8. The method according to any one of the preceding claims, wherein, during operation of the fuel cell systems (FCS1, FCS2), the method is updated with a predetermined update frequency, such as an update frequency corresponding to a predetermined number of operating hours of at least one of the fuel cell systems.

9. The method according to claim 8, wherein the predetermined update frequency is variable, such as variable with respect to at least one of ambient temperature conditions and ambient weather conditions.

10. The method according to any one of claims 8-9, wherein the predetermined update frequency is modified during operation based on a magnitude of the difference in the actual state of health between the fuel cell systems (FCS1, FCS2).

11. A control unit (110) for controlling operation of at least two fuel cell systems (FCS1, FCS2), wherein the control unit is configured to perform the steps of the method according to any one of claims 1-10.

12. A propulsion system (1) for a vehicle comprising at least two fuel cell systems (FCS1, FCS2), and further comprising a control unit according to claim 11.

13. A vehicle (100) comprising a propulsion system according to claim 12.

14. A computer program comprising program code means for performing the steps of any of claims 1-10 when said program is run on a computer, such as on the control unit according to claim 11.

15. A computer readable medium carrying a computer program comprising program code means for performing the steps of any of claims 1-10 when said program is run on a computer, such as on the control unit of claim 11.

## Patentansprüche

1. Computerimplementiertes Verfahren zum Steuern des Betriebs von mindestens zwei Brennstoffzellensystemen (FCS1, FCS2), wobei jedes Brennstoffzellensystem so ausgelegt ist, dass es mit einer einstellbaren Betriebsdynamik und/oder in einem einstellbaren Betriebsfenster, das die Betriebsbeschränkungen des Brennstoffzellensystems definiert, betrieben wird, wobei das Erhöhen der Betriebsdynamik und/oder des Betriebsfensters im Zusammenhang mit einer erhöhten erwarteten Verschlechterung des Brennstoffzellensystems steht, und wobei das Reduzieren der Betriebsdynamik und/oder des Betriebsfensters im Zusammenhang mit einer reduzierten erwarteten Verschlechterung des Brennstoffzellensystems steht, wobei das Verfahren Folgendes umfasst:
- Erhalten (S1) eines geschätzten tatsächlichen Gesundheitszustands jedes Brennstoffzellensystems (FCS1, FCS2),
- Vergleichen (S2) der tatsächlichen Gesundheitszustände der Brennstoffzellensysteme (FCS1, FCS2), und wenn der Vergleich eine vordefinierte Differenz zwischen den tatsächlichen Gesundheitszuständen der Brennstoffzellensysteme (FCS1, FCS2) anzeigt:
- Identifizieren (S3) eines ersten Brennstoffzellensystems der mindestens zwei Brennstoffzellensysteme (FCS1, FCS2), das den schlechtesten tatsächlichen Gesundheitszustand der mindestens zwei Brennstoffzellensysteme (FCS1, FCS2) aufweist,
- Vergleichen (S4) des tatsächlichen Gesundheitszustands des ersten Brennstoffzellensystems mit einem bestimmten erwarteten Gesundheitszustand des ersten Brennstoffzellensystems, wobei der erwartete Gesundheitszustand auf den historischen Nutzungsbedingungen des ersten Brennstoffzellensystems basiert, und
- wenn der tatsächliche Gesundheitszustand des ersten Brennstoffzellensystems schlechter ist als sein erwarteter Gesundheitszustand, Reduzieren (S5) der Betriebsdynamik und/oder des Betriebsfensters des ersten Brennstoffzellensystems und Erhöhen (S5) der Betriebsdynamik und/oder des Betriebsfensters des anderen Brennstoffzellensystems.

2. Verfahren nach Anspruch 1, wobei, wenn der Vergleich der tatsächlichen Gesundheitszustände der Brennstoffzellensysteme (FCS1, FCS2) keine Differenz zwischen den tatsächlichen Gesundheitszuständen der Brennstoffzellensysteme (FCS1, FCS2) anzeigt, das Verfahren das Betreiben der Brennstoffzellensysteme mit der gleichen Betriebsdynamik und/oder im gleichen Betriebsfenster umfasst.

3. Verfahren nach einem der vorhergehenden Ansprüche, wobei das Ergebnis des Vergleichs der tatsächlichen Gesundheitszustände der Brennstoffzellensysteme (FCS1, FCS2) die vordefinierte Differenz anzeigt, wenn eine Differenz einen vordefinierten Differenz-Schwellenwert überschreitet.

4. Verfahren nach einem der vorhergehenden Ansprüche, das ferner Folgendes umfasst:
- wenn der tatsächliche Gesundheitszustand des ersten Brennstoffzellensystems besser ist als sein erwarteter Gesundheitszustand, Betreiben der Brennstoffzellensysteme (FCS1, FCS2) mit der gleichen Betriebsdynamik und/oder im gleichen Betriebsfenster.

5. Verfahren nach einem der vorhergehenden Ansprüche, wobei das Reduzieren der Betriebsdynamik und/oder des Betriebsfensters des ersten Brennstoffzellensystems und das Erhöhen der Betriebsdynamik und/oder des Betriebsfensters des anderen Brennstoffzellensystems derart durchgeführt wird, dass eine kombinierte Betriebsdynamik und/oder ein kombiniertes Betriebsfenster der mindestens zwei Brennstoffzellensysteme (FCS1, FCS2) unverändert bleiben/bleibt.

6. Verfahren nach einem der vorhergehenden Ansprüche, wobei das Verfahren als Reaktion auf das Erhalten einer Anforderung zum Aktivieren aller der mindestens zwei Brennstoffzellensysteme (FCS1, FCS2) initiiert wird.

7. Verfahren nach einem der vorhergehenden Ansprüche, wobei die historischen Nutzungsbedingungen des ersten Brennstoffzellensystems mindestens eines von Folgendem umfassen:
- Leistungsausgang des Brennstoffzellensystems während des Betriebs,
- Betriebsdynamik des Brennstoffzellensystems während des Betriebs,
- Leistungszyklusfrequenz des Brennstoffzellensystems während des Betriebs,
- Umgebungstemperaturbedingungen während des Betriebs,
- Umgebungsluftbedingungen während des Betriebs, wie etwa der Verschmutzungsgrad,
- Umgebungswetterbedingungen während des Betriebs,
- Start-/Stopp-Verlauf,
- Verlauf der Kühlmitteltemperatur im Brennstoffzellensystem,
- Betriebszeit.

8. Verfahren nach einem der vorhergehenden Ansprüche, wobei das Verfahren während des Betriebs der Brennstoffzellensysteme (FCS1, FCS2) mit einer vorbestimmten Aktualisierungsfrequenz aktualisiert wird, wie etwa einer Aktualisierungsfrequenz, die einer vorbestimmten Anzahl von Betriebsstunden mindestens eines der Brennstoffzellensysteme entspricht.

9. Verfahren nach Anspruch 8, wobei die vorbestimme Aktualisierungsfrequenz variabel ist, wie etwa variabel in Bezug auf die Umgebungstemperaturbedingungen und/oder die Umgebungswetterbedingungen.

10. Verfahren nach einem der Ansprüche 8-9, wobei die vorbestimmte Aktualisierungsfrequenz während des Betriebs basierend auf der Differenz des tatsächlichen Gesundheitszustands der Brennstoffzellensysteme (FCS1, FCS2) modifiziert wird.

11. Steuereinheit (110) zum Steuern des Betriebs von mindestens zwei Brennstoffzellensystemen (FCS1, FCS2), wobei die Steuereinheit dazu konfiguriert ist, die Schritte des Verfahrens nach einem der Ansprüche 1-10 durchzuführen.

12. Antriebssystem (1) für ein Fahrzeug, das mindestens zwei Brennstoffzellensysteme (FCS1, FCS2) umfasst und ferner eine Steuereinheit nach Anspruch 11 umfasst.

13. Fahrzeug (100), das ein Antriebssystem nach Anspruch 12 umfasst.

14. Computerprogramm, das Programmcodemittel zum Durchführen der Schritte nach einem der Ansprüche 1-10 umfasst, wenn das Programm auf einem Computer, wie etwa in der Steuereinheit nach Anspruch 11, ausgeführt wird.

15. Computerlesbares Medium, das ein Computerprogramm enthält, das Programmcodemittel zum Durchführen der Schritte nach einem der Ansprüche 1-10 umfasst, wenn das Programm auf einem Computer, wie etwa in der Steuereinheit nach Anspruch 11, ausgeführt wird.

## Revendications

1. Procédé mis en œuvre pour commander le fonctionnement d'au moins deux systèmes de piles à combustible (FCS1, FCS2), dans lequel chaque système de piles à combustible est conçu pour fonctionner avec une dynamique de fonctionnement réglable et/ou dans une fenêtre de fonctionnement réglable définissant des contraintes de fonctionnement pour le système de piles à combustible, l'augmentation de la dynamique de fonctionnement et/ou de la fenêtre de fonctionnement est associée à une dégradation attendue accrue du système de pile à combustible et la réduction de la dynamique de fonctionnement et/ou de la fenêtre de fonctionnement est associée à une dégradation attendue réduite du système de pile à combustible, le procédé comprenant les étapes consistant à :
- obtenir (S1) une estimation de l'état de marche réel de chaque système de pile à combustible (FCS1, FCS2),
- comparer (S2) les états de marche réels des systèmes de pile à combustible (FCS1, FCS2) et, lorsque la comparaison indique une différence prédéfinie entre les états de marche réels des systèmes de pile à combustible (FCS1, FCS2) :
- identifier (S3) un premier système de piles à combustible des au moins deux systèmes de piles à combustible (FCS1, FCS2) présentant un état de marche réel le plus faible des au moins deux systèmes de piles à combustible (FCS1, FCS2),
- comparer (S4) l'état de marche réel du premier système de piles à combustible avec un état de marche attendu déterminé du premier système de piles à combustible, l'état de marche attendu étant basé sur les conditions d'utilisation historiques du premier système de ce dernier et,
- lorsque l'état de marche réel du premier système de pile à combustible est pire que l'état de marche attendu, réduire (S5) la dynamique de fonctionnement et/ou la fenêtre de fonctionnement du premier système de pile à combustible et augmenter (S5) la dynamique de fonctionnement et/ou la fenêtre de fonctionnement de l'autre système de pile à combustible.

2. Procédé selon la revendication 1, dans lequel, lorsque la comparaison des états réels d'état de marche des systèmes de piles à combustible (FCS1, FCS2) indique l'absence de différence entre les états réels d'état de marche des systèmes de piles à combustible (FCS1, FCS2), le procédé comprend le fonctionnement des systèmes de piles à combustible avec la même dynamique de fonctionnement et/ou dans la même fenêtre de fonctionnement.

3. Procédé selon l'une quelconque des revendications précédentes, dans lequel le résultat de la comparaison entre les états réels de marche des systèmes de pile à combustible (FCS1, FCS2) indique la différence prédéfinie lorsqu'une différence entre eux dépasse un seuil de différence prédéfini.

4. Procédé selon l'une quelconque des revendications précédentes, comprenant en outre l'étape consistant à :
- lorsque l'état de marche réel du premier système de pile à combustible est meilleur que l'état de marche attendu, faire fonctionner les systèmes de piles à combustible (FCS1, FCS2) avec la même dynamique de fonctionnement et/ou dans la même fenêtre de fonctionnement.

5. Procédé selon l'une quelconque des revendications précédentes, dans lequel la réduction de la dynamique de fonctionnement et/ou de la fenêtre de fonctionnement du premier système de pile à combustible et l'augmentation de la dynamique de fonctionnement et/ou de la fenêtre de fonctionnement de l'autre système de pile à combustible sont effectuées de telle sorte que la dynamique de fonctionnement combinée et/ou une fenêtre de fonctionnement combinée des au moins deux systèmes de piles à combustible (FCS1, FCS2) reste inchangée.

6. Procédé selon l'une quelconque des revendications précédentes, le procédé étant lancé en réponse à l'obtention d'une demande d'activation de tous les au moins deux systèmes de piles à combustible (FCS1, FCS2).

7. Procédé selon l'une quelconque des revendications précédentes, dans lequel les conditions d'utilisation historiques du premier système de pile à combustible comprennent au moins l'un des paramètres suivants :
- puissance de sortie du système de pile à combustible pendant le fonctionnement,
- dynamique de fonctionnement du système de pile à combustible pendant le fonctionnement,
- fréquence des cycles d'alimentation du système de pile à combustible pendant le fonctionnement,
- conditions de température ambiante pendant le fonctionnement,
- conditions de l'air ambiant pendant le fonctionnement, telles que le niveau de pollution,
- conditions météorologiques ambiantes pendant le fonctionnement,
- historique de démarrage/arrêt,
- historique de la température du liquide de refroidissement dans le système de pile à combustible,
- durée de fonctionnement.

8. Procédé selon l'une quelconque des revendications précédentes, dans lequel, pendant le fonctionnement des systèmes de pile à combustible (FCS1, FCS2), le procédé est mis à jour avec une fréquence de mise à jour prédéterminée, telle qu'une fréquence de mise à jour correspondant à un nombre prédéterminé d'heures de fonctionnement d'au moins un des systèmes de pile à combustible.

9. Procédé selon la revendication 8, dans lequel la fréquence de mise à jour prédéterminée est variable, telle que variable par rapport à au moins une des conditions de température ambiante et de conditions météorologiques ambiantes.

10. Procédé selon l'une quelconque des revendications 8 à 9, dans lequel la fréquence de mise à jour prédéterminée est modifiée pendant le fonctionnement sur la base d'une amplitude de la différence dans l'état de marche réel entre les systèmes de pile à combustible (FCS1, FCS2).

11. Unité de commande (110) pour commander le fonctionnement d'au moins deux systèmes de pile à combustible (FCS1, FCS2), l'unité de commande étant configurée pour exécuter les étapes du procédé selon l'une quelconque des revendications 1 à 10.

12. Système de propulsion (1) pour véhicule, comprenant au moins deux systèmes de piles à combustible (FCS1, FCS2), et comprenant en outre une unité de commande selon la revendication 11.

13. Véhicule (100) comprenant un système de propulsion selon la revendication 12.

14. Programme informatique comprenant un moyen de code de programme pour exécuter les étapes de l'une quelconque des revendications 1 à 10 lorsque ledit programme est exécuté sur un ordinateur, comme sur l'unité de commande selon la revendication 11.

15. Support lisible par ordinateur comportant un programme informatique comprenant un moyen de code de programme pour exécuter les étapes de l'une quelconque des revendications 1 à 10 lorsque ledit programme est exécuté sur un ordinateur, comme sur l'unité de commande selon la revendication 11.
